# EUROPEAN PATENT APPLICATION

(11) **EP 4 738 729 A1**
(43) Date of publication of application: **06.05.2026**
(21) Application number: 23943631.4
(22) Date of filing: 28.06.2023
(51) Int. Cl.: H04B 10/40, H04B 10/50, H04B 10/60

(54) **OPTICAL TRANSCEIVER, AND METHOD AND APPARATUS FOR MANUFACTURING SAME**

(71) Applicant: NTT, Inc., Tokyo 100-8116 (JP)
(72) Inventor: OZAKI Josuke, Musashino-shi, Tokyo 180-8585 (JP); OGISO Yoshihiro, Musashino-shi, Tokyo 180-8585 (JP); NUNOYA Nobuhiro, Musashino-shi, Tokyo 180-8585 (JP)
(74) Representative: Samson & Partner Patentanwälte mbB
(86) International application number: PCT/JP2023/024039
(87) International publication number: WO 2025/004234

(57) **Abstract**

Provided are a configuration for achieving an optical transceiver capable of operating at an ultra-high speed, and a manufacturing method and a manufacturing device for the same. An optical transceiver according to the present disclosure includes at least one optical module mounted on a PCB, a DSP, and an FPC that connects the DSP and the optical module, wherein the FPC further includes a first connection PAD on a first surface solder-connected to a PAD on a terrace surface of the optical module, a second connection PAD on a second surface solder-connected to a PAD on an upper surface of a DSP substrate, both side surfaces, and the first connection PAD, the FPC and the first connection PAD and the FPC and the second connection PAD are connected by one or more through-holes or buried VIAs, and the through-hole has a diameter of ϕ100 µm or more.

## Description

### Technical Field

The present disclosure relates to an optical transceiver used in optical communication, and a manufacturing method and a manufacturing device for the same.

### Background Art

In order to cope with increasing communication traffic demand, a high-speed optical modulator and an optical receiver compatible with an advanced optical modulation system are required. In optical modulators and optical receivers in early 100G digital coherent communications systems, each of the components is packaged and these parts are mounted on a printed circuit board (PCB). For example, in the case of an optical modulator, a driver IC and an optical modulator chip are individually packaged, and the packaged IC and chip are mounted on the PCB. In the case of an optical receiver, a transimpedance amplifier (TIA) and an optical light-receiving chip are individually packaged and mounted as separate parts on the PCB.

In a digital coherent communications system exceeding 400G with further advanced speed, an optical modulator and an optical receiver are also required to have a wide band so as to be able to handle a signal of 40 GHz or more, and it is necessary to reduce high-frequency loss and reduce a size. In the case of the optical modulator, the driver IC and the optical modulator chip are integrally mounted in one package as an optical module. Also in the case of the optical receiver, the TIA and the optical light-receiving chip are integrally mounted as a single optical module. Also for a signal format for inputting and outputting a baseband signal, design from a single-ended format to a differential format has been generalized as one of means for achieving high speed, small size, and low power consumption. At present, device development for achieving 800 Gbps and 1 Tbps (128 GBd operation) is in progress.

The optical internetworking forum (OIF) has standardized under the name of a high-bandwidth coherent driver modulator (HB-CDM) as an optical transmitter in which a driver IC and an optical modulator are mounted in an integrated package. In Non Patent Literature 1, physical configurations, interface specifications, and the like are defined as various types of modules. Also on the reception side, the TIA and the optical light receiver are mounted in an integrated package, which is also called high-bandwidth intradyne coherent receiver (HB-ICR). An optical transceiver (optical transmission/reception device) includes a transmission-side (Tx) optical module and a reception-side (Rx) optical module.

Initially, in the above-described optical module, a surface mount (SMT) type package having excellent mountability has been used. In the optical module of the SMT type package, since the optical module is mounted on the PCB of the optical transceiver, a via (VIA) structure for passing a high-frequency electric signal into the package is essential. In the VIA, deterioration of high frequency characteristics and the like are inevitable, and thus the VIA structure is a structure not suitable for further achieving a wide band. In addition, in the SMT type package, in a connection portion between a lead pin and a ceramic package, the high-frequency transmission characteristics of an electric signal are also deteriorated due to electromagnetic field mode mismatching or impedance mismatching (Non Patent Literature 2). Therefore, a package configuration using a flexible printed circuit (FPC) is newly standardized (Non Patent Literature 1).

Optimization design including a digital signal processor (DSP) is important in achieving an increase in speed of the entire optical transceiver in addition to an increase in speed of an individual optical module. In early optical transceivers, a DSP, a transmission module, and a reception module are mounted in separate packages and mounted at separate locations on a PCB. For this reason, there is a limit to speed up of the optical transceiver due to propagation loss generated in the individual packages or on the PCB. As one of the solutions, a "co-package structure" in which an optical modulator chip, an optical receiver chip, and a DSP are mounted close to each other in a single package has also been studied. This structure is ideal that can greatly reduce the loss of a high-frequency electric signal, but the DSP, which is the largest heat generation source, is disposed close to the periphery of the optical modulator or the optical receiver. When an optical modulator that requires temperature control, such as an InP modulator that is excellent in speed, is used, the optical modulator chip needs to be mounted on a Peltier element. The Peltier element has a risk of an increase in power consumption and thermal runaway, and it is difficult to mount the Peltier element in a single package in proximity to the DSP that causes heat inflow. The co-package structure has various problems in terms of mounting processes. Therefore, another configuration of the optical transceiver has been proposed (Patent Literature 1).

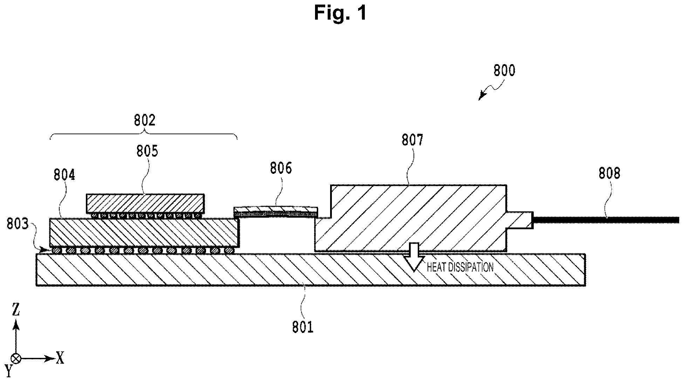

Fig. 1 is a side sectional view illustrating a configuration of an optical transceiver 800 according to conventional art adapted for high speed. A side cross section (z-x plane) of the optical transceiver 800 is illustrated taken along a line through a transmission module 807 mounted on a substrate surface (x-y plane) of a PCB 801. The optical transceiver 800 includes a DSP 802, the transmission module 807, and a reception module, which is not illustrated. In the DSP 802, a DSP chip 805 is mounted on a DSP substrate 804 using a ball grid array (BGA). The entire DSP 802 is further mounted on the PCB 801 via a BGA 803. The transmission module 807 includes a driver IC, an optical modulator chip, and the like, which are not illustrated, in a package having a terrace, and includes an optical fiber 808.

In the optical transceiver 800, a high-frequency (RF) signal is connected between the DSP 802 and the optical module 807 using an FPC 806. By using the FPC 806 as an RF interface, an RF signal line formed on the upper surface of the DSP substrate 804 and an RF signal line on the terrace of the optical module are directly connected. In an earlier optical transceiver including an optical module of an SMT type package, a signal path passing through the VIA of the DSP substrate 804, an RF signal line pattern of the PCB 801, and the VIA of the package of the optical module 807 is configured. The optical transceiver 800 of Fig. 1 is configured to minimize high-frequency losses as compared to earlier optical transceivers that utilize the SMT type package. In addition, options of optical modulators are not limited unlike optical transceivers having a co-package structure, and mounting is more feasible. It is also possible to sufficiently suppress the high-frequency loss as compared with earlier optical transceivers using the SMT type package.

However, in the optical transceiver 800 of the conventional art in Fig. 1, a specific connection configuration between the FPC 806 and the DSP substrate 804, a structure of the FPC 806, and a connection configuration between the FPC 806 and the optical module 807 are not clear. The configurations of the DSP and the DSP substrate are not clear either. In addition, in the transmission module 807 of Fig. 1, a heat generation component such as the driver IC inside the package is thermally connected to the side where the terrace is located and the PCB side, and the heat dissipation direction is downward with respect to the optical transceiver 800 (-z direction). On the other hand, since the DSP chip 805 is on the upper side in the DSP 802, the heat dissipation direction is upward with respect to the optical transceiver (+z direction). The heat dissipation is divided into two directions, which is not preferable for simplifying the heat dissipation structure.

### Citation List

### Patent Literature

Patent Literature 1: WO 2021/171599 A

### Non Patent Literature

Non Patent Literature 1: OIF, Implementation Agreement for the High Bandwidth Coherent Driver Modulator (HB-CDM), [online], July 15,2021, [Searched on January 20, 2023], the Internet <URL: https://www.oiforum.com/wp-content/uploads/OIF-HB-CDM-02.0.pdf>
Non Patent Literature 2: J. Ozaki et al., "Over-85-GHz-Bandwidth InP-Based Coherent Driver Modulator Capable of 1-Tb/s/λ-Class Operation," in Journal of Lightwave Technology, vol. 41, no. 11, pp. 3290-3296, 1 June1, 2023, doi: 10.1109/JLT.2023.3236962.

### Summary of Invention

An object of the present disclosure is to present a configuration of a smooth high-frequency connection between a DSP and an optical module in an optical transceiver and to provide a configuration for achieving an optical transceiver capable of operating at an ultra-high speed, and a manufacturing method and a manufacturing device for the same.

Based on the above object, the present disclosure provides an optical transceiver, including: at least one optical module that is mounted on a printed circuit board (PCB); a digital signal processor (DSP) that is mounted on the PCB; and a flexible printed circuit (FPC) that connects the DSP and the optical module, wherein the DSP includes a DSP chip mounted on a DSP substrate formed of a multilayer wiring substrate having a core layer for adjusting a thickness, the FPC includes a first connection PAD of a first surface solder-connected to a PAD of a terrace surface of the optical module and a second connection PAD of a second surface solder-connected to a PAD of an upper surface of the DSP substrate, the FPC and the first connection PAD, and the FPC and the second connection PAD are connected by one or more through-holes or buried VIAs, the FPC further includes a land connected to the through-hole or the buried VIA and formed on a surface of the FPC, and a notch having a diameter of ϕ200 µm or more capable of stable holding on both side surfaces of the FPC and at positions 500 µm or more away from an inner end of each of the first connection PAD and the second connection PAD, and the through-hole has a diameter of ϕ100 µm or more.

In addition, the present disclosure provides a manufacturing device for manufacturing the optical transceiver, the manufacturing device including: a hot bar that contacts the FPC and applies heat and a load to solder formed between the first connection PAD and the PAD on the DSP substrate and between the second connection PAD and the PAD on a terrace; a mounting base that holds the PCB from below; and a holding mechanism that holds the FPC from a side surface and a lower surface by fitting with the notch.

Further, the present disclosure provides a manufacturing method for manufacturing the optical transceiver, the method including: mounting a DSP on the PCB; connecting the optical module and the FPC by soldering using a hot bar; installing the optical module to which the FPC is connected on the PCB, and connecting the FPC and the DSP by soldering using a hot bar; and connecting the PCB and a DC interface of the optical module, wherein the FPC and the first connection PAD, and the FPC and the second connection PAD are through-holes, the manufacturing method further including: performing pre-solder treatment of forming solder on at least the land or the heating PAD directly heated by the hot bar in soldering using the hot bar; and heating and pressurizing, with the hot bar, the solder formed by the pre-solder treatment, wherein the solder melted by the heating and pressurizing reaches between the first connection PAD and the terrace and between the second connection PAD and the DSP substrate through the through-hole, and the solder is formed between the first connection PAD and the terrace and between the second connection PAD and the DSP substrate, or the FPC and the first connection PAD, and the FPC and the second connection PAD are connected by the buried VIA, the manufacturing method further including: performing pre-solder treatment of forming solder between the first connection PAD and the terrace and between the second connection PAD and the DSP substrate in soldering using the hot bar; and heating and pressurizing the land or the heating PAD with the hot bar, wherein the solder formed by the pre-solder treatment is melted by heat transfer from the heated and pressurized land or heating PAD, and the solder is formed between the first connection PAD and the terrace and between the second connection PAD and the DSP substrate.

### Brief Description of Drawings

Fig. 1 is a side sectional view illustrating an optical transceiver configuration according to conventional art adapted for high speed.
Fig. 2 is a top view and a cross-sectional view illustrating an outline of a configuration of an optical transceiver of the present disclosure.
Fig. 3 is an enlarged cross-sectional view of an optical module including a connection part of an FPC.
Fig. 4 is a view illustrating an FPC wiring layout in the optical transceiver of the present disclosure.
Fig. 5 is a flowchart illustrating a procedure of a manufacturing method 600 for an optical transceiver 100 according to the present disclosure.
Fig. 6 is a side sectional view illustrating a configuration of a mounting device 700 for the optical transceiver 100 according to the present disclosure.
Fig. 7 is a view illustrating in detail a structure of a holding mechanism 704 when the optical transceiver 100 according to the present disclosure is mounted, Fig. 7(a) illustrates a top view of an FPC 500-1 in a state where the holding mechanism 704 and a notch 512 are fitted to each other, Fig. 7(b) illustrates a cross-sectional view taken along line VIIbc-VIIbc, and Fig. 7(c) illustrates a cross-sectional view taken along line VIIbc-VIIbc in a case where the holding mechanism 704 has another form.
Fig. 8 is a view illustrating a detailed structure of a DSP substrate 201 of the optical transceiver 100 according to the present disclosure, Fig. 8(a) illustrates a top view, and Fig. 8(b) illustrates a cross-sectional view taken along line Xb-Xb.
Fig. 9 is a view illustrating a cross-sectional structure in a Tx module in the optical transceiver of the present disclosure.

### Description of Embodiments

Hereinafter, various embodiments of the present disclosure will be described in detail with reference to the drawings. The same or similar reference signs denote the same or similar components, and redundant description may be omitted. The numerical values are for purposes of illustration and are not intended to limit the scope of the present disclosure. In addition, the following description is an example, and some configurations may be omitted, modified, or implemented together with additional configurations without departing from the gist of an embodiment of the present disclosure.

An optical transceiver according to the present disclosure presents a specific configuration that implements smooth high-frequency connection between a DSP and an optical module. The optical module may include an optical receiver module and an optical modulator module. The optical transceiver may include two separate optical modules, or may include a single optical module in which functions of both the optical receiver and the optical modulator are integrated. For the high-frequency connection, a flexible substrate (hereinafter, the FPC) is used. The FPC electrically connects a PAD on the upper surface of the DSP substrate and a PAD of the package of the optical module using both surfaces. The connection PAD on one surface of the FPC is connected to a DSP substrate side, and the connection PAD on the other surface is connected to an optical module side. A DSP chip may be mounted on the DSP substrate in the DSP, and the entire DSP may be covered with a lid except for a region of the DSP substrate connected to the FPC.

A detailed structure of a connection PAD on a DSP substrate, a shape of a high-frequency wiring, a structure of a multilayer wiring substrate, and a structure of an FPC for avoiding deterioration of transmission characteristics of a high-frequency signal due to impedance mismatching, high-frequency crosstalk, and the like is disclosed. Hereinafter, a detailed configuration of the optical transceiver will be described with reference to the drawings.

In the following description, for the sake of simplicity, a transmission-side optical module including an optical modulator and its driver IC is referred to as a "Tx module", and a reception-side optical module including a photodetector (PD) and a TIA is referred to as an "Rx module". A single optical module in which functions of both the Tx module and the Rx module are integrated is referred to as a TRx module. In the following description, an optical transceiver including an Rx module and a Tx module is described as an example, but two modules may be replaced with one TRx module. In addition, in the following description, the description will be made based on the cross section of the Tx module, but the connection form of the DSP and the optical module using the FPC is the same for the Rx module having a substantially symmetrical shape with the Tx module. The similar configuration of the PAD shape of the FPC between the DSP and the Tx module and the PAD shape of the FPC between the DSP and the Rx module is efficient also in terms of high-frequency design. It is also possible to suppress variations in solder mounting quality and connection strength in the entire optical module.

### [Basic Configuration of Optical Transceiver]

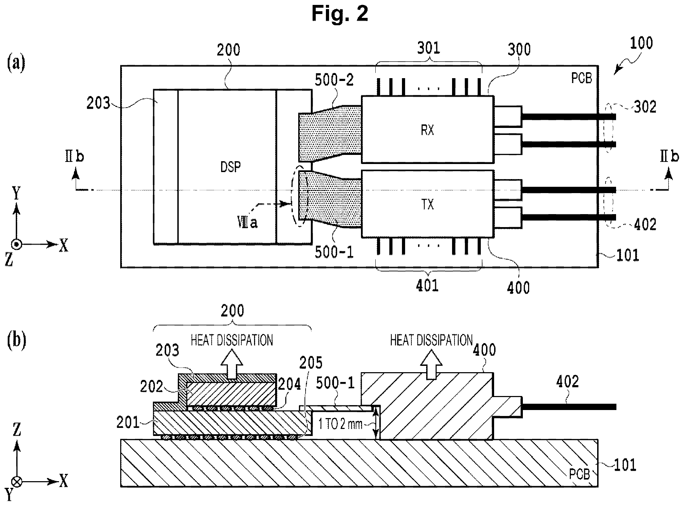

Fig. 2 is a top view and a cross-sectional view illustrating an outline of a configuration of an optical transceiver of the present disclosure. (a) of Fig. 2 is a top view of a substrate surface (x-y plane) of a PCB 101, and (b) of Fig. 2 is a side sectional view (x-z plane) taken along IIb-IIb passing through a Tx module 400. In the optical transceiver 100, a DSP 200, an Rx module 300, and the Tx module 400 are mounted on the PCB 101.

In addition, various electric components and mechanical components such as a chip capacitor and a resistor are mounted on the upper surface and the lower surface of the PCB 101, but are omitted in Fig. 1. In the optical transceiver 100, the heat dissipation surfaces of the DSP 200, the Rx module 300, and the Tx module 400 are aligned in one direction in consideration of manufacturability when each part is mounted on the PCB 101, simplification of the heat dissipation structure of the optical transceiver, and the like. Considering that heat generation from a DSP chip 202 is the largest in the optical transceiver, it is desirable to align the direction of heat dissipation upward (+z direction) that is appropriate for heat dissipation of the DSP chip 202.

Referring to the cross-sectional view in (b) of Fig. 2, in contrast to the configuration of the conventional art, the optical transceiver 100 is disposed such that the upper and lower surfaces in a state of being mounted on the PCB 101 are inverted and the side on which the terrace is located is the upper side in the height direction (z axis) of the optical module. The optical module is mounted such that the terrace surface faces the upper surface of the PCB, and in the case of the Tx module 400, heat from the driver IC and the Peltier element is configured to move toward the side where the terrace surface of the package is located (in the +z direction).

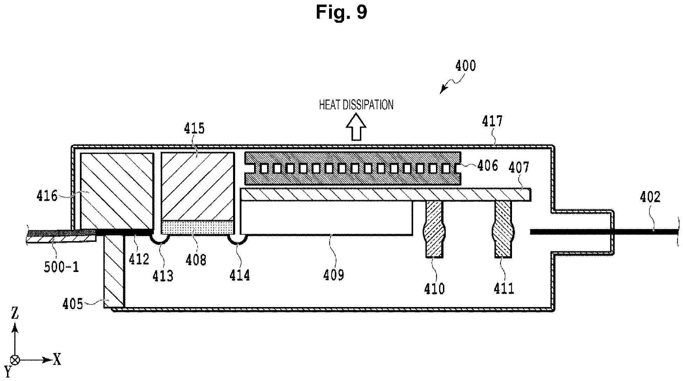

Fig. 9 is a view illustrating a cross-sectional structure in a Tx module in the optical transceiver of the present disclosure. In the Tx module 400, a Peltier element 406, a substrate 407, and an optical modulator chip 409 are disposed in this order inside a housing 417. On the substrate, lenses 410 and 411 are provided and optically coupled to an optical fiber 402. In the module, a driver IC 408 is formed on the surface of a base 415, and wiring 412 is formed on a package base 416. The optical modulator chip 409 to the wiring 412 are connected by wires 413 and 414. The inside and the outside of the module are partitioned by the housing 417, the package base 416, and a package sidewall 405. A terrace surface of the optical module is configured by exposing a part of the package base 416 from the housing. An FPC 500-1 is connected to the terrace surface.

The Peltier element 406 for temperature control and the base 415 thermally connected to the driver IC, which is a heat generation component, are fixed to an upper surface inside the housing 417. Heat dissipation from the inside of the module is configured such that heat moves from the driver IC or the Peltier element to the outside in the +z direction. Also in the Rx module, a TIA is provided instead of the driver IC, and heat from the inside of the module moves to the upper side (+z direction) of the module.

In the package of the optical module, a heat generation component is mounted so as to dissipate heat toward a bottom surface opposite to a mounting surface on the PCB. Accordingly, it is possible to adopt a heat dissipation mechanism (housing) in which one common heat dissipation surface, which is not illustrated, is disposed on the upper side of the optical transceiver 100 with respect to heat dissipation from the DSP 200 and heat dissipation from the Tx module 400. The optical module and the DSP are disposed close to each other, and at the same time, the DSP and the optical module have the same upper surface height, so that heat dissipation of the DSP and the optical module can be easily performed with a single heat dissipation mechanism. In the case of a common heat dissipation mechanism, it is necessary to sufficiently consider that heat does not move from the DSP to the optical module. In addition, in order to suppress such movement of heat via the heat dissipation mechanism, a separate heat dissipation mechanism on the same plane can be used for the DSP and the optical module.

The DSP 200 includes the DSP substrate 201 including a multilayer wiring substrate described below, the DSP chip 202, and a lid (cover) 203. The DSP chip 202 and the DSP substrate 201 are connected by a BGA 204. Similarly, the DSP substrate 201 and the PCB 101 are also connected by a BGA 205.

The lid 203 is made of an integrated metal so as to cover at least the entire region of the upper surface of the DSP chip 202 and a region excluding a region to which the FPCs 500-1 and 500-2 are connected/fixed on the upper surface of the DSP substrate. The lid 203 may cover a side surface of the DSP chip 202 and may protrude from the periphery of the DSP substrate 201. The lid 203 prevents unexpected damage from being directly applied to the DSP chip, the BGAs 204 and 205, which are connection portions, and the like due to a handling error or the like when the DSP 200 is mounted on the optical transceiver or during a manufacturing process. By finely contriving the shape of the lid 203, it is possible to bring the surface of the DSP substrate 201 from an RF connection PAD for connection with the FPC to a substrate end into an open state. As described above, the DSP 200 can be prepared as a DSP module in a state where the DSP chip 202 and the lid 203 are mounted on the DSP substrate 201. Although the manufacturing process of the optical transceiver will be described below, when the DSP is prepared in the form of a lidded DSP module, the DSP can be safely mounted on the PCB 101 without causing damage in the manufacturing process, similarly to the Rx module and the Tx module.

As another form of the DSP 200, it is also possible to prepare in a state where only the DSP chip 202 is mounted on the DSP substrate without the lid. It is also possible to connect the DSP 200 without the lid and the optical modules 300 and 400 with the FPCs 500-1 and 500-2, respectively, and then finally attach the lid 203. When the lid is mounted, there may be a risk that an inadvertent force is applied to the FPC or the wiring of the FPC is short-circuited by the lid 203. Therefore, it is necessary to sufficiently optimize the PAD position of the region including the connection PAD on the upper surface of the DSP substrate 201 and the shape of the lid. Since the DSP chip and the DSP substrate are exposed until immediately before the lid is mounted, it is necessary to pay careful attention so as not to damage the DSP chip and the like.

When the DSP 200 includes the lid 203, the footprint of the lid 203 is always smaller than the footprint of the DSP substrate 201 on the substrate surface (x-y plane). On the other hand, the footprint of the DSP chip 202 is included in the footprint of the lid. On the substrate surface of the DSP substrate 201, the lid 203 is not provided only in the region where at least the RF connection PAD is provided.

In the manufacturing process of the optical transceiver, when damage to the DSP chip and the BGAs 204 and 205 can be avoided, the lid can be omitted. In order to effectively release heat dissipated from the DSP chip to the outside of the optical transceiver, the lid may be simply provided only on the upper surface of the DSP chip. The shape of the lid 203 can be variously modified, and specific variations will be described below.

The Rx module 300 and the Tx module 400 are each housed in a package. The two optical modules 300 and 400 and the DSP 200 are directly connected by the FPCs 500-1 and 500-2 as RF interfaces for electric signals. Here, "directly" connected means that the connection PAD on the terrace of the optical module and the connection PAD on the DSP substrate are connected only via the FPCs 500-1 and 500-2. Accordingly, in the optical transceiver 100, there is no high-frequency path through the VIA connecting the optical module to the PCB, the RF signal line in the PCB, the BGA connecting the PCB and the DSP substrate, and the VIA in the DSP substrate. In the optical transceiver 100, an electric signal does not pass through a VIA or a BGA that leads to deterioration of high frequency characteristics, as compared with an optical transceiver including an optical module of an SMT type package of the conventional art. The DSP and the optical module can be connected by the shortest high-frequency path, and high-frequency loss can be greatly reduced. In addition, since the number of connection portions such as the VIA, the BGA, and the like is reduced, the configuration of the optical transceiver of Fig. 2 is very effective also from the viewpoint of reducing the high-frequency loss due to impedance mismatching occurring at a discontinuous portion of the high-frequency path.

The direct current (DC) interface of the optical modules 300 and 400 can be, for example, DC lead pins 301 and 401 as in (a) of Fig. 2. The DC interface is not limited to the lead pin structure, and an FPC may be used similarly to the RF interface with the DSP 200. The DC lead pins 301 and 401 are solder-mounted on a PAD, which is not illustrated, of the PCB 101 so that power can be supplied from the outside of the optical transceiver.

Referring again to the top view of the optical transceiver 100 in (a) of Fig. 2, the Rx module 300, the Tx module 400, and the DSP 200 are optimally disposed to minimize the loss of an RF signal, which is a high-frequency electric signal. The two modules and the DSP 200 are disposed symmetrically relative to the center line along a longitudinal direction of the PCB 101. In order to achieve a high-speed optical transceiver, it is important to suppress a high-frequency loss of an RF signal from the DSP 200 to the Tx module and an RF signal from the Rx module to the DSP 200. In the optical transceiver 100 of Fig. 2 in which the lengths of the FPCs 500-1 and 500-2 functioning as the RF interfaces need to be as short as possible, it is preferable to bring a distance (gap) in a y-axis direction of the two optical modules close to 1 mm or less in order to transmit a high-speed signal of more than 128 GBd.

In order to disposed the two optical modules close to each other, it is necessary to collect the DC lead pins on one side of each module and face the DC lead pins in opposite directions. As illustrated in (a) of Fig. 2, the DC lead pins 401 of the Tx module 400 are directed toward the outer periphery of the PCB 101 in a -y-axis direction (downward in the figure), and the DC lead pins 301 of the Rx module 300 are directed toward the outer periphery of the PCB 101 in a +y-axis direction (upward in the figure). This configuration follows the direction of the lead pin defined in the HB-CDM standardized by the OIF as described in Non Patent Literature 1.

The package of the optical module is made of ceramic. Considering the layout design of the high-frequency signal line and the DC line in the optical module, the height from the upper surface of the PCB 101 to the terrace surface of the optical module in the cross-sectional view of (b) of Fig. 2 is desirably about 1 to 2 mm. The thickness of the DSP substrate 201 is desirably similarly set in a range of about 1 to 2 mm from the viewpoint of matching the height with the terrace surface of the optical module. By matching the upper surface of the DSP substrate with the height of the terrace surface, bending is unnecessary in the thickness direction of the FPC as described later, and flattening is performed.

When the DSP substrate has a thickness of about 1 to 2 mm, more layers than necessary for the DC line and the RF line can be used. In general, in a multilayer wiring substrate, it is desirable to minimize the number of layers as much as possible in terms of cost, and thus a core layer for adjusting the thickness of the entire substrate can be used inside. The multilayer wiring substrate including such a core layer may be referred to as a build-up substrate. The core layer functions as a separation layer that separates an RF wiring layer and a DC wiring layer in addition to adjust the entire substrate thickness. By providing the core layer, the DC layer and the RF wiring layer can be largely separated from each other, so that mutual interference between the wiring layers and an effect of noise can be suppressed. A detailed configuration of the DSP substrate will be described below together with detailed configurations of the PAD and the signal line.

In consideration of high-speed DSP operation as described above, the DSP 200 is desirably accommodated in the DSP substrate 201 having a small size in order to suppress the loss of a high-frequency signal and the cost. The two FPCs should be configured to converge on the center line of the DSP 200 from the optical module side toward the DSP side. As will be described below, the FPCs illustrated in Fig. 2 both have a shape bent in a plane (x-y plane) of the base material, which is previously shaped into a predetermined shape. Although it is also possible to form the FPCs in a straight line shape without bending, it is necessary to spread and dispose the PAD in a fan shape on the substrate surface of the DSP substrate 201. The high-frequency loss on the DSP substrate increases, and the size of the DSP substrate also increases, which is not desirable.

### [Connection Form between DSP and Optical Module of Optical Transceiver]

The optical transceiver 100 of the present disclosure has one feature in a connection form of the FPC between the DSP and the optical module. In the optical transceiver 800 of the conventional art illustrated in Fig. 1, the FPC 806 is on a common plane of the substrate surface of the DSP substrate 804 and the terrace surface of the optical module 807 in the same direction, and is connected only on one surface of the FPC 806. On the other hand, in the optical transceiver 100 in (a) of Fig. 2, the FPC 500-1 is on a common plane of the substrate surface of the DSP substrate 201 and the terrace surface of the Tx module 400 in the opposite direction, and is connected on different surfaces of the FPC 500-1. The optical module 400 is mounted on the PCB 101 upside down with respect to the conventional art such that the terrace surface having the connection PAD for the FPC faces the PCB 101 side.

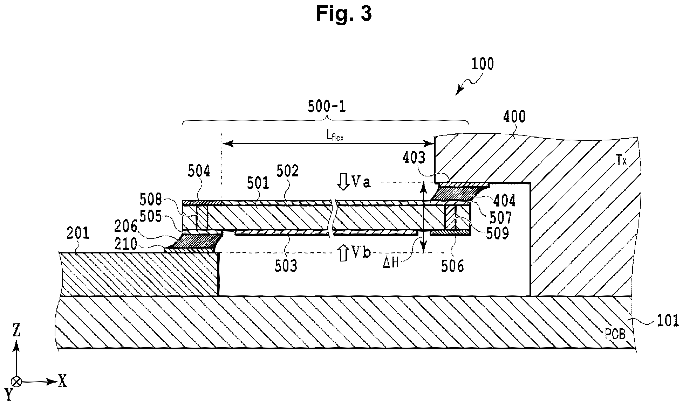

Fig. 3 is an enlarged cross-sectional view of an optical module including a connection part of an FPC. This is a side cross section (x-z plane) obtained by enlarging the vicinity of the FPC 500-1 of (b) of Fig. 2, and the height direction (z-axis direction) is enlarged and indicated. In addition, it should be noted that, in order to make the configuration in the vicinity of the FPC easy to understand, the relative size relationship of each part is not accurately drawn. Fig. 3 and (b) of Fig. 2 are cross-sectional views taken along line IIb-IIb in (a) of Fig. 2 and perpendicular to the PCB surface, which cross the signal line of the bent FPC 500-1, but are illustrated along the signal line in the FPC. In the optical transceiver 100 of the present disclosure, in order to reduce the high-frequency loss caused by bending the FPC in the thickness direction (z-axis direction), a configuration that minimizes the FPC bending is adopted.

Fig. 3 illustrates the FPC 500-1 that connects a connection PAD 210 at the end of the DSP substrate 201 and a connection PAD 403 on the terrace surface of the Tx module 400. In the FPC 500-1, metal layers are formed on both surfaces of a base material 501, and a signal line 502 is provided on the upper side in the drawing, and a ground (GND) surface 503 is provided on the opposite side. A PAD 504 and a connection PAD 507 with the optical module are formed at both ends of the signal line 502. A connection PAD 505 with the DSP that is connected to the PAD 504 via a VIA or a through-hole 508 and a PAD 506 connected to the connection PAD 507 via a VIA or a through-hole 509 are also formed on the GND surface side. As described below, by heating the PAD 504, the connection PAD 505 and the connection PAD 210 are connected by solder 206. Similarly, by heating the PAD 506, the connection PAD 507 and the connection PAD 403 are connected by solder 404.

In the optical transceiver 100 according to the present disclosure, a height difference ΔH between the terrace surface of the Tx module and the upper surface of the DSP substrate 201 is set to 500 µm or less in order to minimize bending of the FPC in the thickness direction. When the difference in height is up to about 500 µm, it is not necessary to bend the FPC largely in the thickness direction, and the FPC can be connected almost flat. High-frequency loss and a risk of cracking in metal wiring on the FPC due to large bending of the FPC are suppressed, and favorable high-frequency connection can be achieved.

The base material 501 of the FPC is generally easier to handle when it is thinner so that the shape in the height direction can be flexibly adjusted in the mounting process. On the other hand, in terms of high frequency characteristics, it is preferable that the base material be thick in order to suppress the loss to be low. In consideration of these, the thickness of the base material 501 is desirably, for example, 50 µm or more. Specifically, when the base material 501 has a thickness of about 50 to 100 µm, even when the difference in height ΔH between the terrace surface and the DSP substrate surface described above is about 500 µm, mounting can be easily performed by slightly adjusting the shape of the FPC in the thickness direction. When ΔH is set to about 500 µm, damage to the solder joint between the FPC and the optical module can also be suppressed in the mounting process. When the solder in the finished state of the solders 206 and 404 at both ends of the FPC becomes thick, the size of the conductor portion of the transmission line changes, and the characteristic impedance of the signal line may decrease. The solder thickness between the PADs is desirably 50 µm or less.

As described above, it is advantageous in terms of high frequency characteristics that the length of the FPC 500-1 is as short as possible. In practice, the effect of heat from the DSP chip 202, which is the largest heat generation source in the optical transceiver, must be considered. When the optical modules 300 and 400 and the DSP chip 202 are brought too close to each other, the optical modules may have a very high temperature. When the optical module includes the Peltier element, there is a risk that the power consumption of the Peltier element greatly increases, or the Peltier element becomes inoperable to cause thermal runaway. In addition, when the FPC is too short, in the process of connecting the FPC to the DSP substrate, there arises a problem that a portion for holding the FPC disappears or a length for bending the FPC cannot be secured. From the viewpoint of thermal design and mountability, the length of the FPC is preferably 3 mm or more.

### [Outline of Procedure for Assembling Optical Transceiver]

An outline of a procedure for mounting the optical transceiver 100 will be described. The Rx module 300 and the Tx module 400 are in a state in which the FPCs are solder-connected to the respective terrace surfaces in advance. First, the DSP 200 is mounted on the PCB 101 by reflow, and then the optical modules 300 and 400 are mounted on the PCB 101. The reason why the optical modules and the DSP are mounted in different processes is that it is difficult to pass the optical modules through a normal reflow process due to restriction of heat resistance or the like.

First, the respective FPCs of the optical modules 300 and 400 are solder-connected to the connection PADs 210 of the DSP 200. Then, the DC lead pins 301 and 401 of the optical modules are fixed onto the PCB 101. Since the FPC of the optical module is an RF interface, the size of the connection PAD 505 is limited for impedance matching. High-frequency transmission characteristics and connection strength are affected by positional deviation of the PADs facing each other via the solder, and therefore mounting of the optical module with the FPC needs to be performed with very high accuracy. On the other hand, since it is sufficient if the lead pins are unfailingly connected in terms of direct current, the DC PAD size on the PCB side can be increased, and the allowable error of the positional deviation may be relatively large. Therefore, the optical module is connected from the FPC side, and then the lead pins are connected.

In order to reduce the number of processes in mounting the FPC on the DSP 200 mounted on the PCB, it is desirable to heat/solder-mount the Tx module and the Rx module collectively using a hot bar. In order to perform mounting using the hot bar, it is necessary to perform pre-solder treatment on at least one of the connection PAD 505 of the FPC and the connection PAD 210 on the DSP substrate in advance. At least one or more vias (VIAs) or through-holes 508 are necessary as illustrated in Fig. 3 in order to melt the pre-solder described above between the connection PADs with the hot bar so as to perform solder-connection. By pressing the hot bar against the heating PAD 504 from above in Fig. 3, the through-hole 508 transfers the heat of the heating PAD 504 to the solder 206 between the connection PADs 505 and 210. On the other hand, the VIA 508 may be a through-hole instead of the VIA. Here, the through-hole refers to a hole formed penetrating the substrate and an inner surface and the like of the hole are all metallized. In the case of the through-hole, since solder can flow through the hole, it is sufficient if at least one of the connection PAD 505 of the FPC, the heating PAD 504, or the connection PAD 210 on the DSP substrate is pre-solder treated.

The DC lead pins 301 and 401 of the optical modules are DC interfaces, and a slight deviation or the like is allowed as long as electrical connection is established. The PAD size on the PCB can also be set sufficiently wide with respect to the lead pins, and high-precision alignment and mounting methods such as those on the FPC side are not required. The lead pins cannot be bent after being fixed, but the FPC can be bent to some extent. Therefore, after the FPC is fixed first, the FPC can be finely adjusted for connection and fixation of the DC lead pins.

### [Wiring Layout of FPC]

Here, a more specific configuration of the FPC in the optical transceiver 100 of the present disclosure will be described. As illustrated in Fig. 3, the FPC has a structure including the metal layers on both surfaces of the base material 501, the signal line 502 of the high-frequency transmission line is provided on one surface, and the GND surface 503 for the signal line is provided on the other surface. The FPC is desirably configured such that the surface on which the signal line 502 is present faces the terrace surface of the Tx module 400. Conversely, when the FPC is configured such that the signal line 502 faces the substrate surface of the PCB 101 below, the metal wiring pattern on the PCB and the signal line 502 on the FPC may interfere with each other. Due to the effect of this interference, there is a risk of deterioration of high-frequency transmission characteristics of an electric signal input and output between the DSP 200 and the optical module, mixing of noise between the electric signal and the DC signal on the PCB, and the like. As illustrated in Fig. 3, when the GND surface 503 of the FPC 500-1 faces the PCB 101 side, the above-described interference problem does not occur. However, in a case where there is no electric wiring or other parts on the PCB 101, or in a case where a sufficient distance can be taken between the PCB and the FPC, the surface of the signal line of the FPC and the GND surface may be turned upside down from those in Fig. 3.

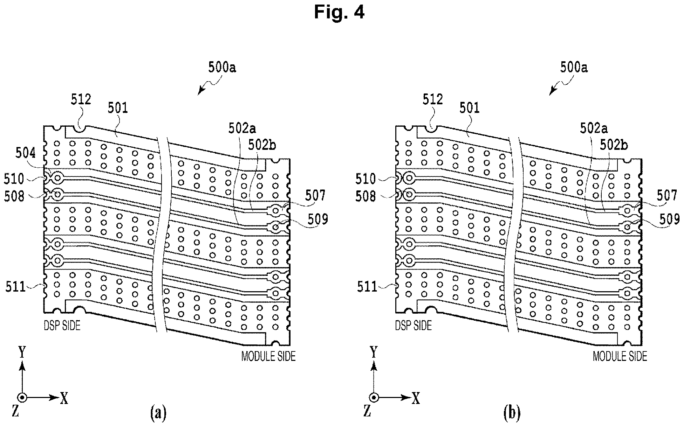

Fig. 4 is a view illustrating an FPC wiring layout in the optical transceiver of the present disclosure. (a) of Fig. 4 illustrates a first surface (x-y plane) on a side where the signal line is present, and (b) illustrates a second surface side (x-y plane) opposite to the first surface and having the GND surface. In Fig. 4, the coverlay and the resist of the FPC are omitted in order to make the layout easily viewable. On the first surface side of an FPC 500a in (a) of Fig. 4, two sets of signal lines 502a and 502b of a GSSG differential type are illustrated as an example. Here, G represents ground, and S represents a signal. The number of sets of signal lines may vary depending on the type of optical module. In addition, the area of the PAD on the GND surface is made larger than that of the PAD for the signal line. From the viewpoint of high frequency characteristics, the PAD for the signal line desirably has a smaller PAD size, but a sufficient area for solder connection is necessary to secure connection strength by the solder. Therefore, the connection strength of the solder can be configured to be secured by making the PAD on the GND side sufficiently wider than the signal line PAD.

The maximum area of the GND PAD between channels is uniquely determined by the inter-channel pitch by the signal line PAD on the FPC and the DSP substrate. When the inter-channel pitch is narrow and the area for the GND PAD cannot be sufficiently secured, it is effective to increase the size of the GND PAD at both ends of the FPC in a width direction (y direction). Since there is a risk of short-circuiting when the solder flows in a region other than the PAD region to be soldered, a region requiring no solder in the FPC is covered with a resist. It should be noted that the GND PAD is also defined on the GND surface by partitioning the PAD region to be soldered by the resist. Accordingly, a plurality of PADs is disposed in the GSSG differential type at the end of the FPC. In addition, since application of the resist to the signal line leads to an increase in high-frequency loss, it is necessary to pay attention to make the area of the resist as small as possible.

The GND surface 503 for the signal lines 502a and 502b is formed on the second surface side of the lower surface of the FPC 500a in (b) of Fig. 4. As illustrated in the cross-sectional view of the FPC connection portion in Fig. 3, the first surface of the FPC having the signal line 502 is connected to the connection PAD of the terrace surface of the optical module 400, and the second surface of the FPC having the GND surface 503 is connected to the connection PAD of the upper surface of the DSP substrate 201. The first surface and the second surface of the FPC are both used for the RF interface. Accordingly, the VIA 508 included in the path of the signal line 502 plays an important role not only as a fixing function by the solder but also as a part of the signal path for transmitting a high-frequency signal.

In order to transmit the high-frequency signal without loss, when the VIA is not disposed at the edge of the PAD portion, a partial region of the PAD away from the VIA forms an open stub, and capacitive impedance is added to the signal line. In order to prevent this, as illustrated in Fig. 4, half through-holes 510 are provided at the endmost portion of the FPC 500a with respect to the signal lines 502a and 502b. When the PAD length is sufficiently short and an impedance change due to stub formation does not become a problem in a used frequency band, the half through-holes are not essential. Similarly, in order to stabilize the high-frequency potential on the GND surface, half through-holes 511 are provided at the endmost portion of the FPC 500a. The half through-holes 510 and 511 not only improve the high frequency characteristics but also lead to formation of a fillet of solder in the connection PAD, and thus help to enhance the solder connection strength. With respect to the half through-holes 510 with respect to the PAD of the signal line, when the half through-hole diameter is too large and the surrounding land area is large, the capacitance at the PAD part increases, leading to a decrease in impedance of the connection PAD and deterioration of high frequency characteristics. In order to suppress deterioration of the high-frequency transmission characteristics in the signal line, it is desirable that the diameter ϕ of the half through-hole 510 is 150 µm or less.

The configuration of the connection PAD and the like of the DSP substrate 201 will be described below, but from the viewpoint of fillet formation at the FPC end portion, it is desirable that the PAD end of the signal line of the FPC and the PAD end of the signal line on the DSP substrate are mounted in position while shifted by about 100 µm. This corresponds to the fact that the end of the connection PAD 210 on the DSP substrate is shifted in the -y direction as compared with the end of the connection PAD 505 in Fig. 3. By setting the size and positional relationship of the connection PADs 505 and 210 in this way, a favorable fillet is formed in the solder 206 at the connection portion, and the strength quality of the solder can be improved. Specifically, the connection PADs 505 and 210 have the same length, and the FPC position can be adjusted and mounted such that the edge positions of the two PADs are shifted in the length direction (x direction). In addition, as in the cross-sectional view illustrated in Fig. 3, it is sufficient if one edges of the connection PADs 505 and 210 are aligned and the length of the connection PAD 505 on the FPC side is shorter than that of the connection PAD 210 on the DSP substrate 201 by about 100 µm. Since the half through-holes 511 at the end of the GND surface do not significantly affect the high frequency characteristics, they may be half through-holes having a large diameter according to necessary connection strength.

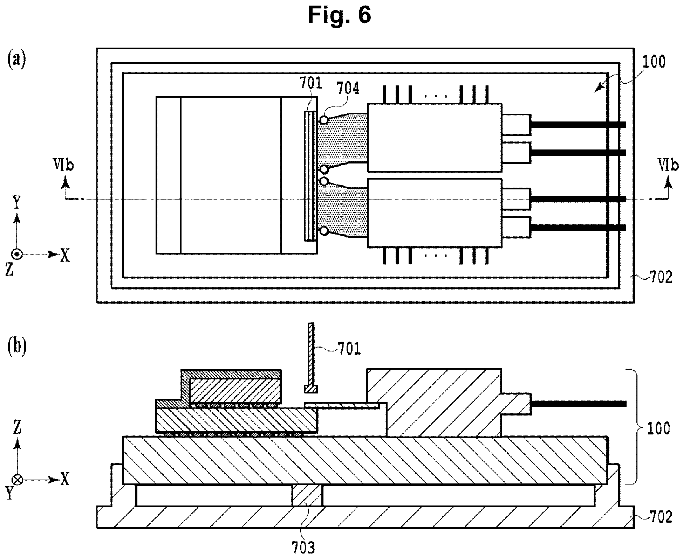

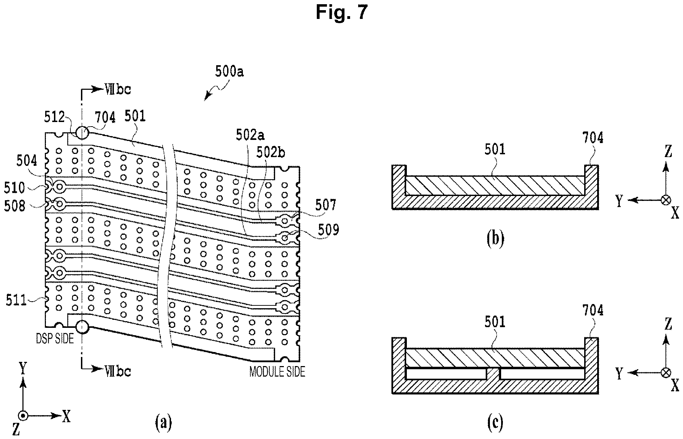

In addition, as illustrated in Fig. 4, the FPCs 500-1 and 500-2 according to the present disclosure further include notches 512 formed on both side surfaces of the base materials 501. The notch 512 has a shape similar to that of the half through-hole 510 or 511 described above, but has a different function, and serves as a fitting portion with a holding mechanism that positions the FPCs 500-1 and 500-2 at the time of mounting and holds the FPCs 500-1 and 500-2 at the time of heating/pressurization using the hot bar. It is desirable that the notch portions of the present FPCs 500-1 and 500-2 are separated from the metal forming the GND and have no metal so that heat is not transmitted when fitted to the holding mechanism. From the same viewpoint, it is desirable that the holding mechanism portion itself is formed of resin or the like rather than metal such that heat is not transmitted. As a result, it is possible to suppress wasteful absorption of heat by portions other than the PAD portion and to apply heat in a concentrated manner to the joint of the PAD. Details of the holding mechanism will be described below with reference to Figs. 6 and 7.

### [Details of Procedure for Assembling Optical Transceiver]

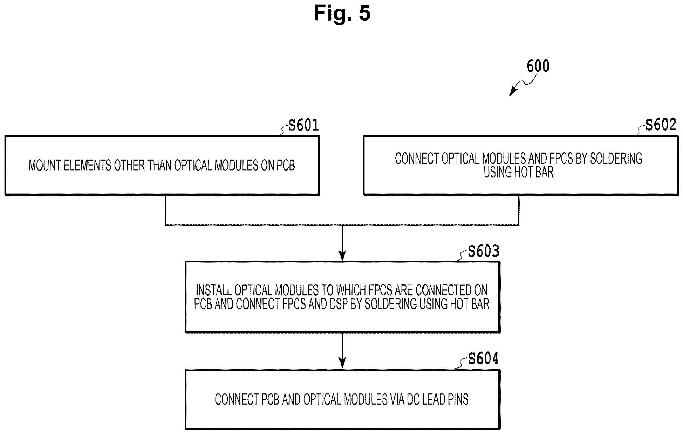

Fig. 5 is a flowchart illustrating a procedure of a manufacturing method 600 for the optical transceiver 100 according to the present disclosure. As illustrated in Fig. 5, the manufacturing method 600 includes mounting other than the optical modules 300 and 400 on the PCB 101 (for example, the DSP 200, other capacitors, which are not illustrated, and the like) (S601), connecting the optical modules 300 and 400 and the FPCs 500-1 and 500-2 by soldering using the hot bar (S602), installing the optical modules 300 and 400 to which the FPCs 500-1 and 500-2 are connected on the PCB 101 and connecting the FPCs 500-1 and 500-2 and the DSP 200 by soldering using the hot bar (S603), and connecting the PCB 101 and the optical modules 300 and 400 via the DC lead pins 301 and 401 (S604).

In S601, elements other than the optical modules 300 and 400 are generally mounted on the PCB by reflow. The reason why mounting the optical modules 300 and 400 is set as a separate process is, as described above, that it is difficult to pass the optical modules through a normal reflow process due to restriction of heat resistance or the like.

In S602, the FPC 500-1 and the Tx module, and the FPC 500-2 and the Rx module 300 are connected by soldering using the hot bar. Details of soldering using the hot bar will be described below by taking S603 (connection between FPCs 500-1 and 500-2 and DSP substrate 201) as an example.

At the time of mounting the FPCs 500-1 and 500-2 in S603, in order to reduce the number of mounting processes and minimize the thermal effect (thermal load) on the DSP 200 and the risk of damage, it is desirable that both the FPCs 500-1 and 500-2 be solder-mounted collectively by the hot bar.

It is desirable to fix the DC-side interface of the optical module in S604 after the connection on the RF interface side in S603. From the viewpoint of impedance matching, it is necessary to use a PAD size having a narrow design tolerance and a very small width such as 100 to 200 µm at the high-frequency connection portion. Therefore, when the position deviates even a little, it is not possible to perform bonding well, or the bonding strength cannot be secured. Further, since there is a possibility that an unexpected connection shape of the solder may lead to impedance mismatching and deterioration of high frequency characteristics, it is necessary to perform mounting with very high accuracy and precision.

### [Soldering Method Using Hot Bar]

Hereinafter, a soldering method using a hot bar in mounting of the optical transceiver according to the present disclosure will be described in detail by taking connection between the FPCs 500-1 and 500-2 and the DSP substrate 201 (corresponding to S603 in Fig. 5) as an example.

In order to perform mounting using a hot bar, it is not possible to heat only the surfaces of the connection portions between the FPCs 500-1 and 500-2 and the DSP substrate 201, and therefore, in practice, it is necessary to apply heat from the upper surfaces of the FPCs 500-1 and 500-2 while applying pressure using the hot bar. Therefore, the FPCs 500-1 and 500-2 need to have a structure in which heat applied from the upper surfaces is transferred to the connection portions with the DSP substrate 201. Therefore, although details will be described below, the FPCs 500-1 and 500-2 of the optical transceiver according to the present disclosure are formed to have metal patterns on both surfaces of the base materials, and have the heating PADs 504 on the upper surfaces and the RF connection PADs 505 on the lower surfaces. In addition, at least one through-hole or buried VIA 508 is formed for each PAD. The through-hole or the buried VIA has a land, and heat or molten solder (only in the case of the through-hole) is transferred on the DSP substrate 201 side via the metal of the land and the through-hole or the buried VIA 508, whereby soldering is performed between the RF connection PAD 505 and the RF connection PAD 210.

In order to effectively transfer the heat applied from the upper surfaces of the FPCs 500-1 and 500-2, the number of the through-holes or buried VIAs is preferably larger and the heating PAD area is preferably larger, but when the number of the through-holes or buried VIAs is increased and the area of the PAD is also increased, the capacitance due to the structure is increased, which leads to a decrease in impedance of the solder connection portion and deterioration of high frequency characteristics. Therefore, the heating PAD may be provided by the land for forming the VIAs or the through-holes. With such a configuration, it is possible to suppress an increase in capacitance. In addition, since the land size increases in size as the diameter of the through-hole or buried VIA increases, it is desirable that the diameter of the through-hole or the buried VIA is as small as possible. However, it should be noted that when the through-hole is less than ϕ100 µm, the flow of solder is significantly reduced, and there is a possibility that stable solder mounting cannot be performed. On the other hand, since it is not necessary to flow the solder through the buried VIA, the buried VIA can be set to a desired size.

In the mounting using the hot bar, it is necessary to perform pre-solder treatment on at least one of the heating PADs of the FPCs 500-1 and 500-2 and the RF connection PAD of the DSP substrate 201 in advance. In the pre-solder treatment, the method is different between the case where the above-described 508 is a through-hole and the case where it is a buried VIA.

In a case where 508 is a through-hole, since the through-hole portion is hollow, it is difficult to efficiently transfer heat applied from the hot bar to the DSP substrate 201 side. Therefore, solder is formed (pre-solder treatment) on the heating PAD 504 in advance using solder paste or the like, and the pre-formed solder is heated/pressurized using the hot bar. In this way, at the same time as the heating, the previously formed solder melts and flows out to the connection portion through the through-hole 508, thereby forming the solder 206. However, from the viewpoint of flowing the solder through the through-hole 508, the diameter of the through-hole 508 is desirably ϕ100 µm or more. Alternatively, a method is also useful in which after the solder paste is applied, the solder portion is subjected to a heating treatment, and the through-hole portion is buried in advance during the pre-solder treatment process. In addition, this pre-solder treatment may be additionally performed on the RF connection PAD 210 on the DSP substrate 201. By doing so, the solder is well spread, and the solder mounting can be stably performed.

On the other hand, when 508 is a buried VIA, molten solder cannot flow even when pre-solder treatment is performed on the heating PAD 504. In this case, the pre-solder treatment is performed on the RF connection PAD 210 on the DSP substrate 201 or on the RF connection PADs 505 on the FPCs 500-1 and 500-2. Thereafter, when the heating PAD 504 is heated/pressurized by the hot bar, heat is applied to the solder formed by the pre-solder treatment through the VIA 508 since the VIA 508 is metal, and the solder 206 is formed. Note that it is sufficient if the pre-solder treatment is applied to at least one of the RF connection PAD 210 or the RF connection PAD 505. In the case of the buried VIA, since the viewpoint of causing the solder to flow through the hole is unnecessary, it is not always necessary to have ϕ100 µm or more as in the case of the through-hole. However, it should be noted that when the diameter becomes too small, the amount of heat transfer decreases. It is desirable to set an appropriate buried VIA diameter from both impedance and heat. For example, considering the flow of heat, a diameter of 50 µm or more is necessary. Note that since it is not possible to provide both the buried VIA and the through-hole for convenience of a general FPC manufacturing process, only one of the buried VIA and the through-hole is necessarily formed.

As described above, regardless of whether 508 is a through-hole or a buried VIA, since the solder 206 is formed by the hot bar via the FPCs 500-1 and 500-2, the setting temperature of the hot bar needs to be set to a temperature higher than the melting temperature of the solder to be used in consideration of the heat insulating effect by the FPCs 500-1 and 500-2. For example, when the thicknesses of the FPCs 500-1 and 500-2 are 50 µm, the temperature of the hot bar needs to be set to +50°C or higher than at least the melting temperature. However, when the temperature of the hot bar is set to be excessively high, excessive heat is transferred to the DSP chip 202 side, and the DSP chip 202 may be damaged. Therefore, it is desirable to perform soldering after monitoring the temperature of the solder with a small thermistor or the like using a thermocouple.

The material of the solder may be SnAgCu-based lead-free solder or the like often used in optical devices, but may be low temperature solder having a melting point of 184°C or lower, based on Sn or Bi, from the viewpoint of suppressing thermal effect on the DSP chip 202 and mounting tolerance.

As described above, in the manufacture of the optical transceiver according to the present disclosure, it is desirable to collectively connect the FPC 500-1 and the FPC 500-2 at the same time using one hot bar. Considering such a premise, the load applied by the hot bar needs to be 10 N or more.

In addition, for example, when the Tx module 400 is an HB-CDM and the Rx module 300 is an HB-ICR, and are mounted with a gap of 1 mm therebetween, the distance from the edge of the FPC 500-1 to the edge of the FPC 500-2 is expected to be about 20 to 30 mm. Accordingly, it is assumed that the length of the hot bar in the Y direction is suitably 20 to 30 mm. In general, it is necessary to set the length in consideration of the temperature distribution of the hot bar. For example, in the case of a type in which heat is applied from the center of the hot bar, the vicinity of the center is long, and the heat is low in the vicinity of both sides, and in this case, it is desirable to increase the length as much as possible so that heating can be performed in the vicinity of the center of the hot bar. However, when the length of the hot bar in the Y direction is excessively long, interference between other elements and members (for example, the lid 203) and the hot bar may occur, and therefore the length of the hot bar in the Y direction needs to be set so as not to interfere with other elements and members.

On the other hand, the sizes of the RF connection PAD 505 and the RF connection PAD 210 are desirably 1 mm or less in length and 0.2 mm or less in width because a high-frequency signal does not pass when the capacitance becomes too large from the viewpoint of securing high frequencies. In addition, the width (length in the X direction) of the hot bar is desirably about the same as or slightly smaller than the sizes of the RF connection PAD 505 and the RF connection PAD 210 (for example, smaller than the PAD size of about 200 to 300 µm) so that the place where the solder 206 is formed can be efficiently heated by the hot bar.

### [Configuration of Mounting Device]

Fig. 6 is a side sectional view illustrating a configuration of a mounting device 700 for an optical transceiver according to the present disclosure. As illustrated in Fig. 6, the mounting device 700 for an optical transceiver according to the present disclosure includes: a hot bar 701 for applying heat and load for forming the solder 206 between the RF connection PAD 505 and the RF connection PAD 210, a mounting base 702 for holding the PCB 101 at the time of mounting, a lower support structure 703 that is disposed between the lower surface of the PCB 101 and the mounting base 702 and supports a portion pressurized by the hot bar 701 from below, and the holding mechanisms 704 that achieve highly accurate alignment of the FPCs 500-1 and 500-2 at the time of mounting and hold the FPCs 500-1 and 500-2 when the FPCs 500-1 and 500-2 are heated/pressurized using the hot bar 701.

In the manufacturing method 600 for an optical transceiver illustrated in Fig. 6, the heat applied by the hot bar 701 needs to be efficiently applied to the RF connection PAD 505 and the RF connection PAD 210. More specifically, the mounting device 700 is configured such that the heat applied by the hot bar 701 is intensively applied to the RF connection PAD 505 and the RF connection PAD 210, and conduction to other elements and release to the outside are suppressed. As an example of such a configuration, as illustrated in Fig. 7, the space between the mounting base 702 of the mounting device 700 and the PCB 101 may be configured to be hollow. Since the space between the mounting base 702 of the mounting device 700 and the PCB 101 is hollow, heat conduction is interrupted in the hollow portion, and heat is intensively applied to the RF connection PAD 505 and the RF connection PAD 210. However, when the space between the mounting base 702 and the PCB 101 becomes hollow, the PCB 101 is deformed (warped) when the load is applied by the hot bar 701, so that the load applied by the hot bar 701 is not sufficiently applied to the place where the aforementioned pre-solder treatment is performed or the RF connection PAD 505 and the RF connection PAD 210. Accordingly, by disposing the lower support structure 703 to have a structure that receives the load applied from the hot bar 701, an appropriate load can be applied to the pre-solder treatment portion on the heating PAD, the RF connection PAD 505, and the RF connection PAD 210. Note that the lower support structure 703 is desirably formed of a material (for example, resin) having low thermal conductivity.

As another example, the mounting device for an optical transceiver according to the present disclosure may be configured to hold the PCB 101 with the mounting base 702 being in contact with the entire lower surface of the PCB 101. In such a case, since there is no hollow portion described above, deformation of the PCB 101 at the time of load application does not occur. Accordingly, the lower support structure 703 is unnecessary. However, in order to efficiently apply heat to the RF connection PAD 505 and the RF connection PAD 210, the mounting base 702 needs to be formed of a material having high heat insulation properties (for example, resin).

The holding mechanism 704 needs to be disposed in the vicinity of the portion with which the hot bar 701 comes into contact in order to facilitate alignment and prevent the FPCs 500-1 and 500-2 from moving at the time of heating and pressurization. In addition, in the holding, when it is attempted to hold the FPCs 500-1 and 500-2 on the flat surfaces, the holding position is not stable. Accordingly, as illustrated in Fig. 7(a), it is desirable that the holding mechanisms 704 have a round bar structure fitted in the notches 512 formed on both side surfaces of the base materials 501 of the FPCs 500-1 and 500-2 described above. When the diameter of the notch 512 is too small, the diameter of the round bar structure to be fit is too small, the holding or the like is not stable, and furthermore, positioning for holding becomes very difficult, so that the notch 512 needs to have a diameter of at least ϕ300 µm or more so that holding can be performed stably. In addition, as illustrated in Figs. 7(b) and 7(c), the holding mechanism 704 has a mechanism that supports only the base materials 501 of the FPCs 500-1 and 500-2 on the side surface and the lower surface. Such a configuration enables stable mounting. In addition, from the same viewpoint as that of the device base described above, it is desirable that the holding mechanism 704 be formed of a material (for example, resin) having high heat insulation properties. However, as illustrated in Fig. 7(c), in a case where the space between the lower surface of the base material 501 and the holding mechanism 704 is hollow, and the notch 512 portion is formed only of a dielectric, the holding mechanism 704 may be formed of a highly electrically conductive material such as metal.

By fixing the holding mechanism 704 having a bar shape to the notch 512, the FPCs 500-1 and 500-2 can be held without moving even at the time of heating/pressurization by the hot bar 701. In addition, in order to prevent the holding mechanism 704 from interfering with the surface of the DSP substrate 201 and the hot bar 701, the notch 512 is desirably disposed at a position separated from the inner end of the RF connection PAD 505 500 µm or more.

### [Configuration of DSP for Achieving Mounting Method]

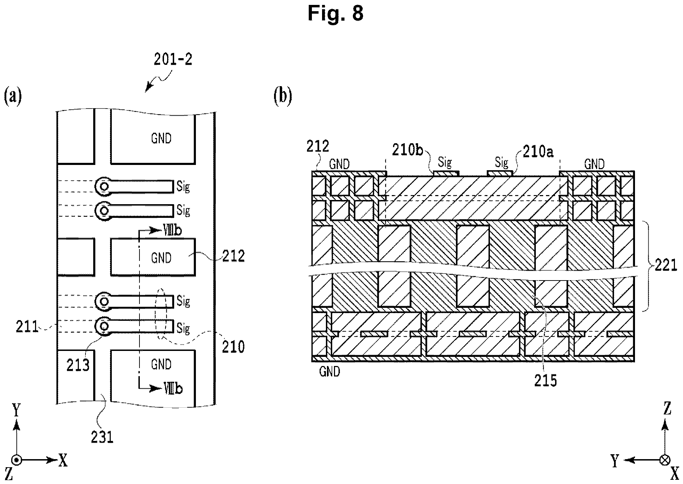

Fig. 8 is a view illustrating a detailed structure of the DSP substrate 201 of the optical transceiver 100 according to the present disclosure, Fig. 8(a) illustrates a top view, and Fig. 8(b) illustrates a cross-sectional view taken along line Xb-Xb. In solder mounting using the hot bar 701 described above, the DSP substrate 201 needs to have a thickness of 1 mm or more (for example, 1 to 2 mm) in order to reduce the risk that the DSP substrate 201 is deformed or damaged by the load applied by the hot bar 701. In order for the DSP substrate 201 to have a thickness of 1 mm or more, a core layer is generally used. This is because, in consideration of high frequency characteristics and the like, the VIA formed in the DSP substrate 201 is desirably ϕ100 µm or less, but in this case, the layer thickness of the build-up substrate that can be used is 100 µm or less. This is because in order to set the thickness of the DSP substrate 201 to 1 mm or more, more layers are necessary than the number of layers necessary for the RF wiring and the DC wiring, and there is a large disadvantage in terms of cost and the like.

In addition, as illustrated in Fig. 8(b), in the DSP substrate 201, not only the core layer is inserted to have a thickness of 1 mm or more, but also a second VIA 215 is disposed in the core layer below the PAD. With such a configuration, the DSP substrate 201 is reinforced, and deformation and breakage in the DSP substrate 201 when pressurized by the hot bar are suppressed. The suppression of such deformation (for example, warpage) is also effective from the viewpoint of achieving uniform load application (suppression of partial contact) at the time of solder mounting. Since the second VIA 215 does not affect the high frequency characteristics, it may be sufficiently larger than other buried VIAs having such as ϕ200 µm or more. In addition, as illustrated in Fig. 8(b), it is desirable that at least one second VIA 215 is formed under each of signal and ground PADs formed on the upper surface of the DSP substrate 201.

In addition, in order to efficiently apply heat to the RF connection PAD 505 and the RF connection PAD 210 and to suppress damage of the BGA 204 and the like due to excessive heat flowing through the DSP chip 202, it is desirable that the ground of the RF connection PAD 210 includes a heat separation portion 231 as illustrated in Fig. 8(a). The heat separation portion 231 has a structure in which the surface metal of the RF connection PAD 210 is separated at a portion where the solder 206 is formed and the other portion (the surface layer metal is not formed only in the heat separation portion 231). By installing such heat separation portion 231, it is possible to suppress that the heat applied from the hot bar 701 is directly propagated to the DSP chip 202 side and the BGA 204 and the DSP chip 202 are damaged by the heat. From the same viewpoint, regarding the signal of the RF connection PAD 210, only the portion where the solder 206 is formed is provided on the surface layer of the DSP substrate 201, and the VIA is provided for the subsequent portions, and the wiring is provided in the inner layer of the DSP substrate 201. In addition, providing a groove for heat separation in the GND metal portion also from the viewpoint of high-frequency wiring would lead to impedance mismatching/deterioration of high frequency characteristics because there is no GND metal in the portion when the portion has surface layer wiring. Therefore, from the viewpoint of securing high frequency characteristics, it is desirable to form inner layer wiring using the VIA at the groove portion or a portion closer to the PAD than the groove portion.

In the above description, the Tx module and the Rx module are separately packaged as an example. However, the configuration of the optical transceiver according to the present disclosure is also effective in an optical transmission/reception module form (such as IC-TROSA) in which an optical modulator and an optical receiver are packaged in the same package, other package forms, or the like.

### Industrial Applicability

The optical transceiver according to the present disclosure can be used for optical communication.

### Reference Signs List

- 100: Optical transceiver
- 101: DSP substrate
- 200: DSP
- 201: DSP substrate
- 202: DSP chip
- 203: Lid
- 206: Solder
- 210: RF connection PAD
- 215: Second VIA
- 231: Heat separation portion
- 300: Rx module (optical module)
- 301: DC lead pin
- 400: Tx module (optical module)
- 401: DC lead pin
- 402: Optical fiber
- 403: RF connection PAD
- 404: Solder
- 405: Package sidewall
- 406: Peltier element
- 407: Substrate
- 409: Optical modulator chip
- 410: Lens
- 411: Lens
- 412: Wiring
- 413: Wire
- 414: Wire
- 415: Base
- 416: Package base
- 417: Housing
- 501: Base material
- 502: Signal line
- 502a, 502b: Signal line
- 503: GND surface
- 504: Heating PAD
- 505: RF connection PAD
- 506: Heating PAD
- 507: RF connection PAD
- 508: VIA or through-hole
- 509: VIA or through-hole
- 510: Half through-hole
- 511: Half through-hole
- 512: Notch
- 600: Manufacturing method
- 701: Hot bar
- 702: Mounting base
- 703: Lower support structure
- 704: Holding mechanism
- 800: Optical transceiver
- 802: DSP substrate
- 804: DSP substrate
- 805: DSP chip
- 807: Transmission module
- 808: Optical fiber

## Claims

1. An optical transceiver, comprising:
at least one optical module that is mounted on a printed circuit board (PCB);
a digital signal processor (DSP) that is mounted on the PCB; and
a flexible printed circuit (FPC) that connects the DSP and the optical module,
wherein
the DSP includes a DSP chip mounted on a DSP substrate formed of a multilayer wiring substrate having a core layer for adjusting a thickness,
the FPC includes a first connection PAD of a first surface solder-connected to a PAD of a terrace surface of the optical module and a second connection PAD of a second surface solder-connected to a PAD of an upper surface of the DSP substrate,
the FPC and the first connection PAD, and the FPC and the second connection PAD are connected by one or more through-holes or buried VIAs,
the FPC further includes
a land connected to the through-hole or the buried VIA and formed on a front surface and a back surface of the FPC, and
a notch having a diameter of ϕ300 µm or more capable of stably holding the FPC on both side surfaces of the FPC and at positions 500 µm or more away from an inner end of each of the first connection PAD and the second connection PAD, and
the through-hole has a diameter of ϕ100 µm or more.

2. The optical transceiver according to claim 1, wherein
the DSP substrate
has a thickness of 1 to 2 mm, and
includes at least one second VIA in the core layer and at each position corresponding to a lower portion of the PAD on the DSP substrate.

3. The optical transceiver according to claim 1, wherein the FPC further includes a heating PAD connected to the land and installed on a surface opposite to a position where the first connection PAD and the second connection PAD are disposed.

4. The optical transceiver according to claim 1, wherein the PAD on the DSP substrate includes a heat separation portion that thermally separates a portion where solder is formed and a portion other than the portion where the solder is formed, and a high-frequency line for connecting the FPC and the DSP chip on the DSP substrate is formed in inner layer wiring of the DSP substrate.

5. A manufacturing device for manufacturing the optical transceiver according to any one of claims 1 to 4, the manufacturing device comprising:
a hot bar that contacts the FPC and applies heat and a load to solder formed between the first connection PAD and the PAD on the DSP substrate and between the second connection PAD and the PAD on a terrace;
a mounting base that holds the PCB from below; and
a holding mechanism that holds the FPC from a side surface and a lower surface by fitting with the notch.

6. The manufacturing device according to claim 5, wherein
the mounting base is configured to be hollow between the PCB and the mounting base, and
the manufacturing device further comprising:
a lower support structure that is disposed between the PCB and the mounting base at a position corresponding to a position where the hot bar comes into contact, and
wherein
the holding mechanism is formed of resin or metal when the notch is formed of only a dielectric, and is formed of resin when the notch is metallized.

7. The manufacturing device according to claim 5, wherein
the hot bar is configured to
have a length of 20 to 30 mm and collectively solder-mount the FPCs connected to an optical transmission module including an optical modulator and a driver integrated circuit and an optical receiver module including a photodetector and a transimpedance amplifier,
contact the FPC at a temperature higher by 50 degrees or more than a melting temperature of the solder, and
apply a load of 10 N or more.

8. A manufacturing method for manufacturing the optical transceiver according to any one of claims 1 to 4, the method comprising:
mounting a DSP on the PCB;
connecting the optical module and the FPC by soldering using a hot bar;
installing the optical module to which the FPC is connected on the PCB, and connecting the FPC and the DSP by soldering using a hot bar; and
connecting the PCB and a DC interface of the optical module,
wherein
the FPC and the first connection PAD, and the FPC and the second connection PAD are through-holes,
the manufacturing method further comprising:
performing pre-solder treatment of forming solder on at least the land or the heating PAD directly heated by the hot bar in soldering using the hot bar; and
heating and pressurizing, with the hot bar, the solder formed by the pre-solder treatment,
wherein
the solder melted by the heating and pressurizing reaches between the first connection PAD and the terrace and between the second connection PAD and the DSP substrate through the through-hole, and the solder is formed between the first connection PAD and the terrace and between the second connection PAD and the DSP substrate, or
the FPC and the first connection PAD, and the FPC and the second connection PAD are connected by the buried VIA,
the manufacturing method further comprising:
performing pre-solder treatment of forming solder between the first connection PAD and the terrace and between the second connection PAD and the DSP substrate in soldering using the hot bar; and
heating and pressurizing the land or the heating PAD with the hot bar,
wherein
the solder formed by the pre-solder treatment is melted by heat transfer from the heated and pressurized land or heating PAD, and the solder is formed between the first connection PAD and the terrace and between the second connection PAD and the DSP substrate.
